(19) **Europäisches Patentamt**

**European Patent Office**

**Office européen des brevets**

(11) **EP 1 199 796 B1**

(12) **EUROPEAN PATENT SPECIFICATION**

(45) Date of publication and mention
of the grant of the patent:
**10.05.2006 Bulletin 2006/19**

(51) Int Cl.:
*H03D 3/00* *(2006.01)*     *H04L 27/34* *(2006.01)*

(21) Application number: **00402891.6**

(22) Date of filing: **19.10.2000**

(54) **Frequency Converter**

Frequenzumsetzer

Convertisseur de fréquence

(84) Designated Contracting States:
**AT BE CH CY DE DK ES FI FR GB GR IE IT LI LU MC NL PT SE**

(43) Date of publication of application:
**24.04.2002 Bulletin 2002/17**

(73) Proprietor: **Norspace AS**
**3189 Horten (NO)**

(72) Inventor: **Indseth, Hakon**
**3677 Notodden (NO)**

(74) Representative: **Grynwald, Albert et al**
**Cabinet Grynwald**
**94, rue Saint Lazare**
**75009 Paris (FR)**

(56) References cited:
**DE-A- 3 508 045**     **US-A- 4 755 761**
**US-A- 5 400 366**     **US-A- 5 517 689**
**US-A- 5 896 421**

**Description**

Field of the invention

The present invention as it is defined in the appended claims relates to frequency conversion, that is: the transfer of electrical signals from one frequency region to another. Specifically the invention is related to frequency conversion systems for improved suppressing of unwanted signal components. A particular field of technology in this respect is the signal splitting or power dividing into two signal components, namely a first component named the I signal, the phase of which is following the phase of the original undivided signal, and a second component named the Q signal, the phase of which being delayed a quarter of a cycle ($\pi/2$ or 90°) from the phase of the original signal. The I and Q signals thereby will be in phase quadrature, and the technique is called I/Q signal processing.

The background of the invention

The shift or transfer of a signal in the frequency domain is generally carried out by bringing the signal together with another signal in a non-linear transfer device. Such a device is called a mixer, and the auxiliary signal to be introduced will usually be the signal from a local oscillator (LO). The mixing of the two signals corresponds to a modulation, even if the expression modulation usually is kept for a signal processing of which the first signal has a relatively low frequency compared to the oscillator signal. The oscillator signal is often named a carrier, a carrier wave signal or similar.

In a mixer having an unlinear transfer function $y = F(x)$, two simultaneously applied sine wave signals $x = a \sin \omega_1 t$ and $X = A \sin \omega_L t$ (the oscillator signal), $\omega = 2\pi f$ being the angular frequency of the signals, f the frequency and t the time, will at the mixer output appear as $y = aF(\sin \omega_1 t) + AF(\sin \omega_L t)$. A mixer having a simple transfer function like $y = x^2$ (a coarse approximation of a diode mixer characteristic) will at the output give:

$$y = A^2 \sin^2 \omega_L t + a^2 \sin^2 \omega_1 t + 2aA \sin(\omega_1 t)\sin(\omega_L t)$$
$$= \frac{1}{2}(A^2 \sin 2\omega_L t + a^2 \sin 2\omega_1 t) + aA[\sin(\omega_L - \omega_1)t + \sin(\omega_L + \omega_1)t]$$

Hence two second order signals are generated (the second harmonic of the two signals) and two first order side-frequency signals symmetrical to the LO frequency (the upper and lower sideband). The amplitude of the output signal in the desired lower sideband will be directly proportional with the amplitude of the two applied signals at the input. Although not apparent from the formulas, these signals will in a practical circuit also to a certain degree leak through from the input to the output.

A transfer function or mixer characteristic may, over a dynamic range of interest and at least approximately, be expressed mathematically or presented through a series development, to a polynomial of the form:

$$y = S_0 + S_1 \sin \omega t + S_2 \sin 2\omega t + S_3 \sin 3\omega t + \ldots$$

In practice said function represents the ratio of an output signal voltage to an input signal voltage, an output signal current to an input control voltage (as the transconductance of a radio valve/tube or generally an electrical conductance) or the ratio of an output signal current to an input control current (as in a transistor or diode) etc. In addition to the leakage transfer mentioned above, a number of signals of higher order are normally generated at the output.

From the literature some references are found, giving the background technique for modulation/mixing:

1. A Direct I/Q Modulator at Microwave Frequencies using GaAs MESFETs, Microwave Journal, October 1994, p. 62 ff.

2. Frequency Translation of a Baseband Signal, by Eric A. Adler, Edward A. Viveros and John T. Clark, Army Research Laboratory, RF Design, p. 41.

3. Introduction to Radar Systems, by Merrill I. Skolnik, ISBN 0-07-057909-1, ch. 9.3: Mixers and ch. 9.4: Low-Noise Front-ends. Many further references are given.

4. Integrated Electronics, by Millman Halkias, ch. 16-8: Delay Equalizer.

5. Analog Devices: High Speed Design Techniques, G2164-10-9/96, ISBN-0-916550-17-6, p. 3-33 and further (RF/IF Subsystems, giving a good description of different mixers and both a mathematical and graphical treatment of image response and third-order intermodulation distortion).

6. Single Sideband for the Radio Amateur, American Radio Relay League (ARRL), 1970, Library of Congress Catalog Card Number: 54-12271.

7. A Simplified Subharmonic I/Q modulator, by I. Doyle, Applied Microwave & Wireless, October 1998, p. 34.

8. Electronic Filter Design Handbook, by Arthur B. Williams, ISBN 0-070430-9.

9. Halvlederteknikk, by Ernö Borbely, Teknologisk Forlag, Oslo, Norway (in Norwegian).

10. Direct Down-Conversion and Demodulation of a QPSK signal at L-band, by Stewart N. Crozier and Ravi Datta, Communiations Research Centre, Ottawa, Canada.

11. US-A-S 896 421

An up-conversion of signals at relatively low frequencies to higher frequencies, for example signals in a baseband (BB) to be converted to an intermediate frequency band (IF) or an output frequency band (RF) by means of a direct mixing process will at the output, as seen, generate three main signals of the first and second order, respectively: A fairly strong LO signal, the desired signal spectrum at the upper or lower LO side, and unwanted image frequency signals at the opposite side (the unwanted sideband). The BB signals will also be transferred through the mixer and represent signals of first order, but will usually appear at low level and may be filtered effectively. Correspondingly there will be generated an unwanted image frequency response when a high frequency signal (at RF or IF) is down-converted to e.g. a baseband.

Both the local oscillator and the image frequency signals can more or less effectively be suppressed by filtering, but the filtering becomes more difficult the broader is the frequency band to be converted.

However, there is some times a main problem that the LO signal is not sufficiently attenuated, together with the requirement for an effective suppression of the unwanted sideband. As the LO signal has a high level at the input of the mixers and thereby calls for mixers having excellent balance specifications, several factors have to be taken into consideration at the design stage. By suitable placing the LO frequency in the stop-band space between two signal channels, where such spaces exist in a communication system, the problem can be reduced. The system specification has to be worked out accordingly, and in order to reduce the possibility for disturbances, the LO signal must among other things be sufficiently attenuated for not causing inter-modulation products in a receiver tuned to a different channel within the same system channel region.

By down-conversion the main problem is the unwanted image frequency band, resulting from the mixing between the LO signal and signals appearing in the opposite sideband. These signals thereby will be down-converted to the same frequency band as the desired band but may be attenuated in a balanced mixer (see ref. [5] p. 3-39). Also the leakage transfer and/or radiation of the LO signal will quite often call for single or double balanced mixers, and RF stages having a good isolation from the output to the input will further be required to improve the result.

To better illustrate the level of balance that could be required, is given that an unwanted sideband attenuation of 55 dB needs a phase response unbalance below 0,2° and a corresponding amplitude level unbalance better than 0,03 dB.

A more direct way for balancing out and thereby suppressing such unwanted signals is to establish two parallel signal channels or paths. In the simplest form this technique is used in balanced mixers to suppress the LO or carrier wave signal. In a more advanced form the technique is also employed for suppressing one of the sidebands, and in this respect the I/Q signal processing will be relevant.

Traditionally the stringent requirements for phase and level balance, however, have been regarded as a hindering bar for moderate to broad band circuit design. One requirement is the need for very steep filters at BB; filters that easily become bulky and complicated, particularly when based upon LC components. Another requirement is the phase quadrature accuracy of the phase shift circuits. The filters therefore must - beyond the requirement mentioned above for slope steepness and sharp response corners - present an extremely flat amplitude response over the pass-band and further have good phase linearity. For wide band coverage the designers thus were facing problems that appeared insuperable and therefore rather looked at corresponding filter method solutions.

Although the I/Q or quadrature method in the principle seems to be the ideal form for transposing a frequency spectrum, there have been a number of practical limitations.

I/Q signal processing can be carried out in passive circuits, but such circuits tend to have very limited bandwidth and are far from phase linear. An example of this is the hybride quadrature coupler disclosed in US Patent 3,484,724. The frequency range is one octave, from 20 to 40 MHz, and the phase difference over this octave band is relatively large, namely around 3°.

The I/Q technique can also be employed in a purely digital system, and signal digitising and processing at BB could give some advantages. However, new problems and disadvantages are likely to appear, particularly those related to aliasing. If further the signals to be converted are non-digital in the first place, solutions using analogue to digital converters (ADC) will be fairly complicated, even at limited bandwidths. An expansion into higher frequencies further complicates the situation due to the need for RF filtering and/or lack of tunability.

Without the use of I/Q technique the conventional way to use step-wise frequency conversion (i.a. known from double-superheterodyne receivers) could be tried, but such solutions tend to be rather complicated and will often suffer from drawbacks with respect to performance. A direct conversion using a subsequent advanced filtering at RF can be used in some cases but is rather limited when it comes to the possibility for tuning and adaptation.

Non-withstanding this kind of limitations the I/Q technology still has important advantages. In fact, practically all the necessary channel filtering and amplification can be made at baseband (BB) where steep filters and relatively linear circuits can be produced with good accuracy and a moderate power consumption, for example corresponding to transistor collector currents around 2 mA (DC bias).

Unwanted mixing products will, except for the image frequency band and inter-modulation products, fall outside the frequencies of interest, namely near the uneven harmonics of the LO signal, so that the normally needed RF filtering can be taken care of in simple low-pass filters (LPF) or broad band-pass filters (BPF).

The shielding requirements are also more relaxed, compared to systems having one or more IF levels and more than one conversion. The reason is that it is simpler to isolate signals in a multi-channel system at relatively low frequencies and by the use of few RF modules having only a single LO for each channel. By having only one single LO, few mixing products will be generated (spurious responses), and the choice of intermediate frequency (IF), particularly by wide-band communications will be easier.

By down-conversion the I/Q mixer inherently will be "image suppressing". Another advantage of the I/Q method will be that the inter-modulation products are suppressed without hindering a large dynamic range, as the mixer input signal level is low or moderate. This is due to the fact that the essential part of the amplification is carried out after the channel filtering, in a system portion where the inter-modulation products outside the band normally are non-existent. As known these products are drastically increasing with the level increase, both in mixers and amplifiers. The products are often characterised by the third order inter-modulation distortion, usually called IP3.

Another example of prior art is given in ref. [10] in the reference list, presenting improvements by the use of I/Q signal processing for direct down-conversion and the modulation at 1,5 GHz (the L-band) and modulation type QPSK (quadrature channel phase shift). Although several improvements are obtained, there are still problems to be considered, and on page 508 in the reference the following seven items are given:

1. Inadequate frequency synthesiser resolution (RF step size)
2. Phase-shift error between the I and Q channels
3. Gain imbalance between the I and Q channels
4. Low-pass filter induced signal distortion
5. Low-pass filter mismatch between the I and Q channels
6. Delay mismatch between the I and Q channels
7. Low frequency microphonics, due to large gains at baseband.

Despite the number of advantages mentioned in the preceding paragraphs there obviously is a need for further improvements in the frequency conversion field, particularly by frequency band extensions, without thereby compromising neither the spurious suppression nor the amplitude and phase linearity and corresponding group delay distortion figure.

Fortunately the continuous development of better RF circuit components has given new possibilities, so that i.a. the quadrature method has become even more attractive. As an example wide band mixer units - usually called triple balanced - are today available as integrated circuit chips. The integration brings about a remarkable improvement in the level and phase balance, a typical specification being:

Conversion loss 10 dB,
LO/RF isolation 30 dB,
RF frequency range (input by down-conversion) 5-20 GHz,
IF bandwidth (output) 0-3 GHz.

If such a device or a corresponding assembled unit is used for up-conversion, the typical output spectrum having a desired upper sideband could have the carrier wave, the LO signal, the lower sideband and signals of higher order suppressed 30-50 dB. Additionally the device could be supplied with feedback loops to further improve the balance, even if such additional circuits easily could make the unit rather complex.

Within the radar technology I/Q and such components of recent design is used at the input side, together with front-end low noise amplifiers.

The recent availability of such circuit components at RF and the fact that traditionally low-frequency components like operation amplifiers today also find their use at higher frequencies, provide a natural technical background for the development of circuits having wide bandwidths at BB. A phase-shift stage possibly covering several octaves was a first object of interest.

Summary of the invention

The idea of the invention thus is based upon the development of phase-linear wide band components and briefly comprises the assembly, further development and adaptation of such components to provide wide band mixer stages.

On this background is, in accordance with a first aspect of the invention, provided a phase-linear wide band converter for frequency conversion from a multi-octave baseband (BB) to an RF band and utilising I/Q signal processing, said converter comprising:

a phase linear wide band RF power combiner having a main output port, a first divisional input port and a second divisional input port,

an I/Q mixer stage having a local oscillator (LO), an I/Q wide band power divider comprising an LO input port, a divisional I output port for an in-phase LO signal ($L_I$) and a divisional Q output port for a quadrature phase LO signal ($L_Q$), and two wide band balanced mixers for receiving the LO signals, respectively, at a first input port and for receiving an input I/Q signal ($B_I$, $B_Q$) at a second input port,

impedance matching circuits,

a wide band BB I/Q power divider having a main input port, an in-phase divisional I output port and a quadrature phase divisional Q output port, the divisional output ports of said divider comprising active wide band amplifier stages each having a reactive branch at one input, so as to provide a means for phase shift without introducing amplitude response variations versus frequency,

a single BB low-pass filter (LPF) having a predetermined phase response versus frequency, and

a BB phase correction stage, said low-pass filter (LPF) and phase correction stage being connected in series in the BB signal path at the converter input.

According to a second aspect of the invention there is provided a phase-linear wide band converter for frequency conversion from an RF band to a multi-octave baseband (BB) and utilising I/Q signal processing, said converter comprising:

a phase linear wide band RF power divider having a main input port, a first divisional output port and a second divisional output port,

an I/Q mixer stage having a local oscillator (LO), an I/Q wide band power divider comprising an LO input port, a divisional I output port for an in-phase LO signal ($L_I$) and a divisional Q output port for a quadrature phase LO signal ($L_Q$), and two wide band balanced mixers for receiving the LO signals, respectively, at a first input port and for receiving an input signal (rf) at a second input port,

impedance matching circuits,

a wide band BB I/Q power combiner having a main output port, an in-phase divisional I input port and a quadrature phase divisional Q input port, the divisional input ports of said combiner comprising active wide band amplifier stages each having a reactive branch at one input, so as to provide a means for phase shift without introducing amplitude response variations versus frequency,

a single BB low-pass filter (LPF) having a predetermined phase response versus frequency, and

a BB phase correction stage, said low-pass filter (LPF) and phase correction stage being connected in series in the BB signal path at the converter output.

According to the invention is further preferred that the baseband phase correction stage comprises at least one active circuit having a resistive feedback and a reactive input branch so as to act as an all-pass filter (APF).

Still according to the invention is further preferred that the active BB I/Q power divider or combiner comprises at least one amplifier having resistive feedback and a resistive/capacitive (RC) phase-shift circuit so as to present a predetermined increasing phase response versus frequency.

It is also preferred that the BB low-pass filter (LPF) is a three-stage ladder filter designed for the optimising of phase linearity, phase response and pass-band flatness, and that the baseband (BB) phase correction stage comprises two operational amplifiers, each having a resistive feedback at the inverting input and a parallel resonance circuit from the direct input to ground, thereby providing a two-stage all-pass filter (APF) adapted to match the BB low-pass filter and correct overall phase fluctuations.

Further is preferred that the resistive feedback is comprising resistors adapted for laser beam trimming in a test set-up for automatic performance measurements.

Brief description of the drawings

These and other features and advantages of the present invention will become more apparent from the description set forth below and with reference to the accompanying drawings, wherein:

Fig. 1 illustrates in a functional block diagram the common way to carry out I/Q conversion from a baseband BB to RF,

Fig. 2 is a block diagram of the corresponding I/Q conversion from RF to BB,

Fig. 3 shows a prior art passive hybride circuit with lumped components and one octave band width,

Fig. 4a shows the circuit diagram of a two-stage phase-shift unit using feedback operational amplifiers and being suited for the converter according to the invention,

Fig. 4b is showing a typical circuit diagram of two three-stage phase-shift units using transistors, one unit for the I channel giving the $B_I$ signal and one unit for the Q channel giving the $B_Q$ signal,

Fig. 4c shows a two-stage all-pass unit also using feedback operational amplifiers and being suited for the invention,

Fig. 4d illustrates a typical circuit diagram for the all-pass filter of Fig. 4c,

Fig. 5 shows a three-stage low-pass filter LPF suited for the invention,

Fig. 6 is a plot of the frequency response of a preferred low-pass filter for the converter according to the invention,

Fig. 7a is a plot of the phase response of the units shown in Figs. 4a and 4c and of a typical preferred LPF shown in Fig. 5,

Fig. 7b shows the printout for the group delay of the LPF of Fig. 5,

Fig. 7c illustrates the close match between the group delay of an I and a Q channel according to the invention,

Fig. 8 shows the I/Q balance in the form of the phase difference between two two-stage units of the type shown in Fig. 4a,

Fig. 9 shows the BB phase response of a typical three and a half octave converter according to the invention,

Fig. 10 shows a functional block diagram of the I/Q converter according to the invention, for conversion from a baseband BB to RF (upper drawing) and vice versa (lower drawing),

Fig. 11 gives a typical circuit diagram for the three final circuit blocks of Fig. 4c, and

Fig. 12 demonstrates the frequency response of the circuits of Fig. 11.

Description of the invention

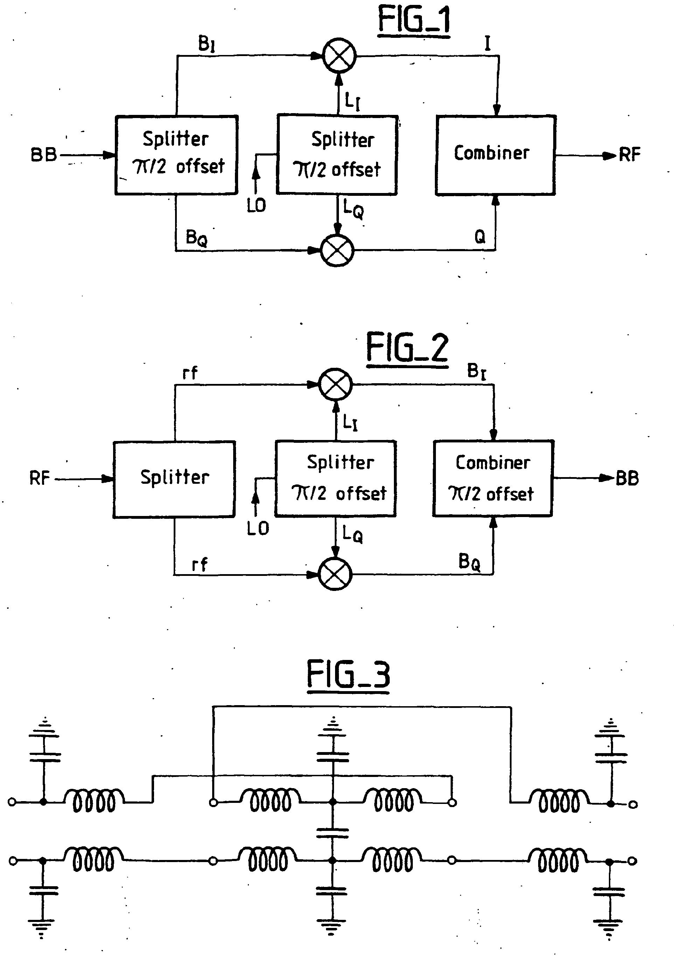

Fig. 1 of the drawings illustrates the prior art principle used by up-converting a baseband signal. According to this principle the baseband (BB) signal to be converted is split in two equal components $B_I$ and $B_Q$ for parallel processing in separate channels. The components are phase shifted to provide a 90° phase difference, hence phase quadrature. The LO signal is processed in the same way, giving the components $L_I$ and $L_Q$ for I/Q mixing, one for each signal channel. In the first channel is thereby generated an RF in-phase component I, while a 90° phase shifted RF quadrature component Q is generated in the second channel. Both these RF signal components will carry the wanted as well as the unwanted mixing product, although the former has the same phase in both channels. The unwanted RF signal component (the image), however, has mutually opposite phase in the two channels and will thereby be suppressed or cancelled when thereafter combined in a combiner, giving an RF signal at its output. In the illustrated example this combiner is phase linear. This principle has been known for quite some time and has been employed practically in many circumstances, see i.a. the list of reference literature above.

Below is shown mathematically how the up-conversion according to Fig. 1 cancel an upper sideband signal at the frequency $\omega_L + \omega_B$ when a BB signal ($\omega_B$) and a LO signal ($\omega_L$) are split in two and brought to phase quadrature ($B_I$ and $B_Q$, $L_I$ and $L_Q$, respectively) before the mixing. The output signal from the mixers are called I and Q, respectively, and the signal amplitudes are for the sake of convenience made equal to 1 at all places. The resulting signal will be the lower sideband signal only, denoted by RF:

$$I = \sin \omega_B t \cdot \omega_L t = \tfrac{1}{2} \left[ \cos(\omega_L - \omega_B)t - \cos(\omega_L + \omega_B)t \right]$$

$$Q = \sin[\omega_B t + \pi/2] \cdot \sin[\omega_L t + \pi/2] = \tfrac{1}{2}\{\cos(\omega_L - \omega_B)t - \cos[(\omega_L + \omega_B)t + \pi]\}$$

$$RF = I + Q = \tfrac{1}{2}[\cos(\omega_L - \omega_B)t - \cos(\omega_L + \omega_B)t + \cos(\omega_L - \omega_B)t - \cos[(\omega_L + \omega_B)t + \pi]$$

$$= \cos(\omega_L - \omega_B)t$$

The corresponding principle also applies for down-conversion, and an I/Q mixer stage for RF input, BB output is shown in Fig. 2. Here the RF signal to be converted is split in two equal components rf without phase shifting for the corresponding parallel processing in the separate channels. The LO signal is split and processed in the same way as before, giving components phase shifted to provide a 90° phase difference, hence phase quadrature components $L_I$ and $L_Q$ for I/Q mixing, one for each signal channel. In the first channel is thereby generated an in-phase BB component $B_I$, while a 90° phase shifted BB quadrature component $B_Q$ is generated in the second channel. Both components will - as in the up-converter described above - carry the wanted as well as the unwanted mixing product, although the former has the same phase in both channels. The unwanted signal (the image), however, has mutually opposite phase in the two channels and will thereby be suppressed or cancelled when thereafter combined in a phase shifting combiner, giving a BB signal at its output.

Fig. 3 shows the circuit diagram of the already mentioned hybride quadrature coupler disclosed in US Patent 3,484,724. The frequency range is one octave, from 20 to 40 MHz, and the phase difference is around 3° over the band.

In the survey given below of the converter according to the invention, its development from this technical background will first be followed briefly, leading on to the description of a representative embodiment having improved specifications.

The development of a phase shifting stage covering at least a decade (more than three octaves) has proved successful by using phase-linear operational amplifiers or lumped components using transistors, and an RC circuit in the feedback path, and the phase shift is quite linear over the full BB frequency range of interest. Two typical such phase-shift operation amplifiers having amplification entirely given by the ratio of the feedback resistances are shown in Fig. 4a. Fig. 4b shows a typical circuit diagram of two three-stage phase-shift units using transistors, one unit for the input I channel (see Fig. 1) giving the $B_I$ signal and one unit for the Q channel giving the $B_Q$ signal. The phase response, however, of both a two-stage and a three-stage unit of this type having two or three amplifying elements and two or three RC stages, respectively will at the lowest frequencies vary significantly over a given frequency interval, although this variation gradually decreases with increasing frequency.

As components for the employment of the I/Q principle, these phase shift stages has turned out to be very well suited, as in fact it is a $\pi/2$ phase difference between two signal paths that is of interest. Two stages looking identical in the circuit diagram of Fig. 4a but having differently dimensioned RC stages are used in each signal channel for the I and Q component, respectively. The phase difference between the channels may be kept fairly constant over the same wide frequency band, even if there is a tendency to a decrease at the lowest frequencies.

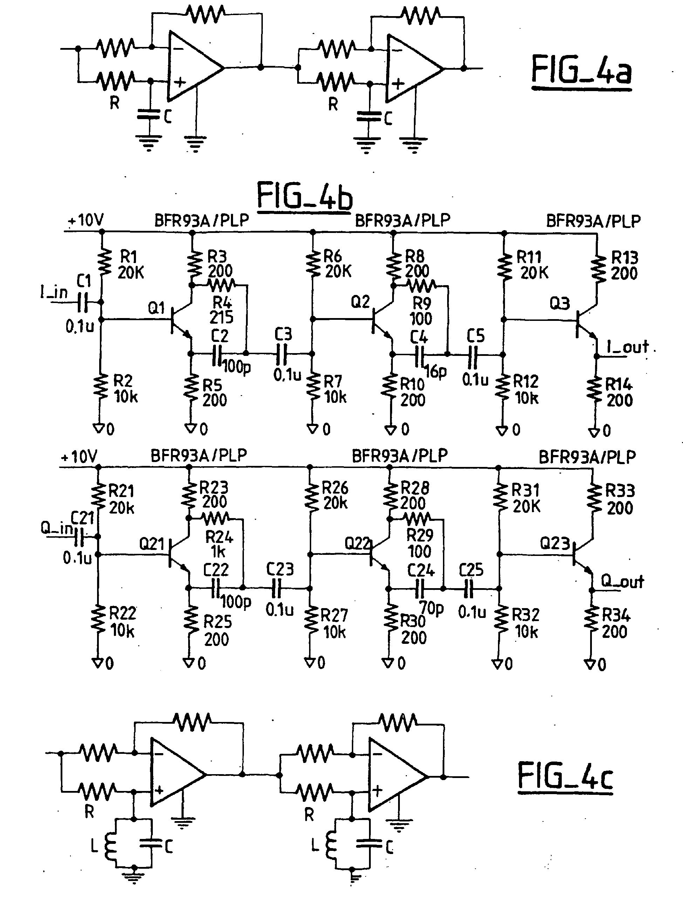

Fig. 4c shows a corresponding two-stage selective phase shifting circuit forming an all-pass unit that covers at least a decade and using phase-linear operational amplifiers. A parallel resonance circuit in the feedback path shifts the phase at a maximum at the resonance frequency, while the amplitude response is flat over the full BB frequency range of interest, which is well known to the professional in the art. Two typical such selective phase-shift operation amplifiers having amplification entirely given by the ratio of the feedback resistances are shown.

Fig. 4d illustrates a typical circuit diagram of a such all-pass filter (APF), in a transistor version and having three stages.

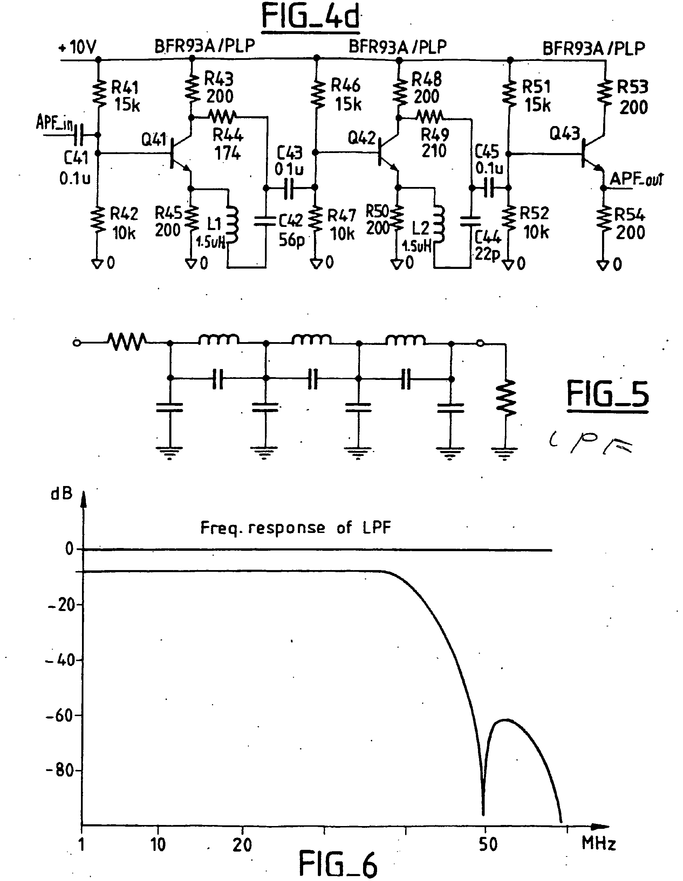

Fig. 5 is a circuit diagram of a low-pass filter (LPF) having three stages and a parallel resonance circuit in each stage. A computer program was developed for first optimising phase linearity, phase response and amplitude flatness over the pass-band, and then modifying the phase response slightly to follow a predetermined normalised phase response, in order to obtain the best possible complementary match to the 90° shifted phase response curves of the I/Q channels.

Fig. 6 illustrates the amplitude response versus frequency of a typical such optimised filter to cover the extended BB with a bandwidth of at least ten times the standard bandwidth of the classical telephone channel (300 - 3000 Hz).

Fig. 7a illustrates graphical the phase response in degrees for this filter LPF (upper curve). A fairly linear phase variation over the frequency band is typical and presenting a phase roll-off at the upper band edge. The two parallel curves with the indicated phase difference of 90° demonstrate the nearly constant phase difference between the I and Q channels, using the feedback amplifiers of Fig. 4a. The phase response of a two-stage all-pass unit or filter (APF) is also indicated in the diagram.

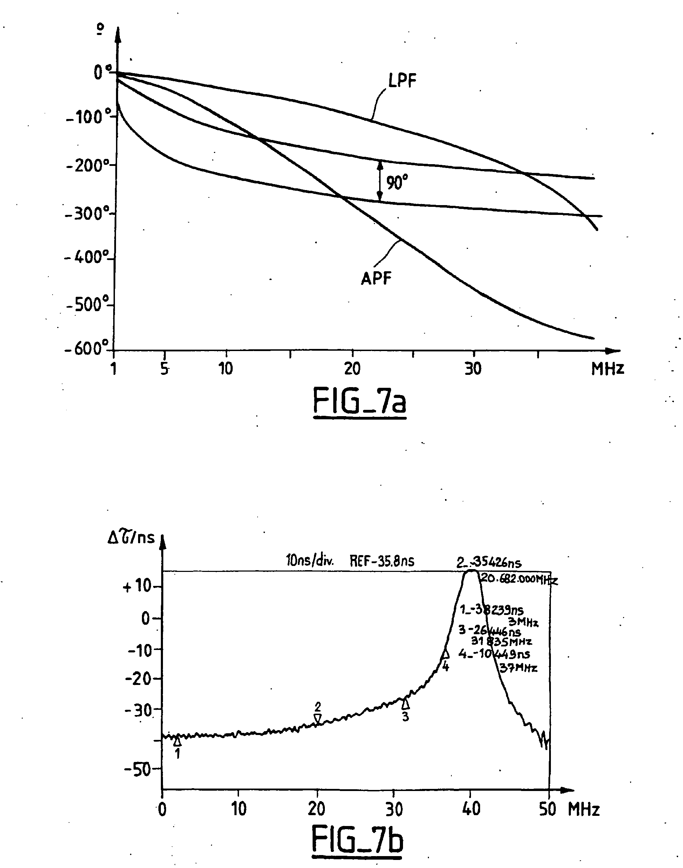

Fig. 7b gives in the form of a printout the group delay of the LPF of Fig. 5, and it is to be recalled that the group delay is the derivative of the phase response of Fig. 7a.

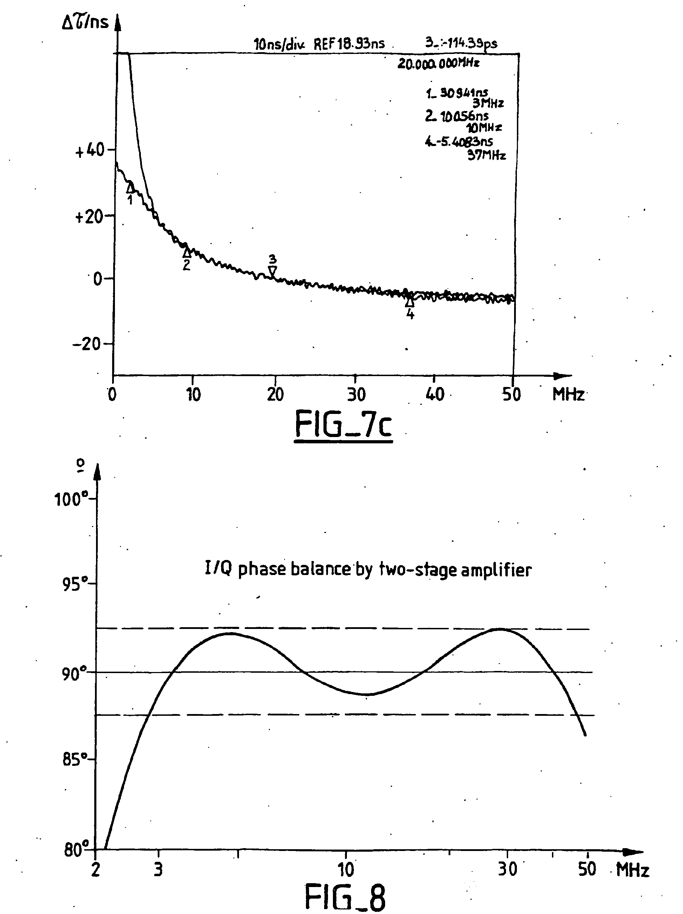

Fig. 7c and Fig. 8 show the I/Q group delay and phase balance, respectively of a two-stage amplifier according to Fig. 4a. The phase balance is 90 $\pm$ 2,5° over the frequency range 2,9-46 MHz.

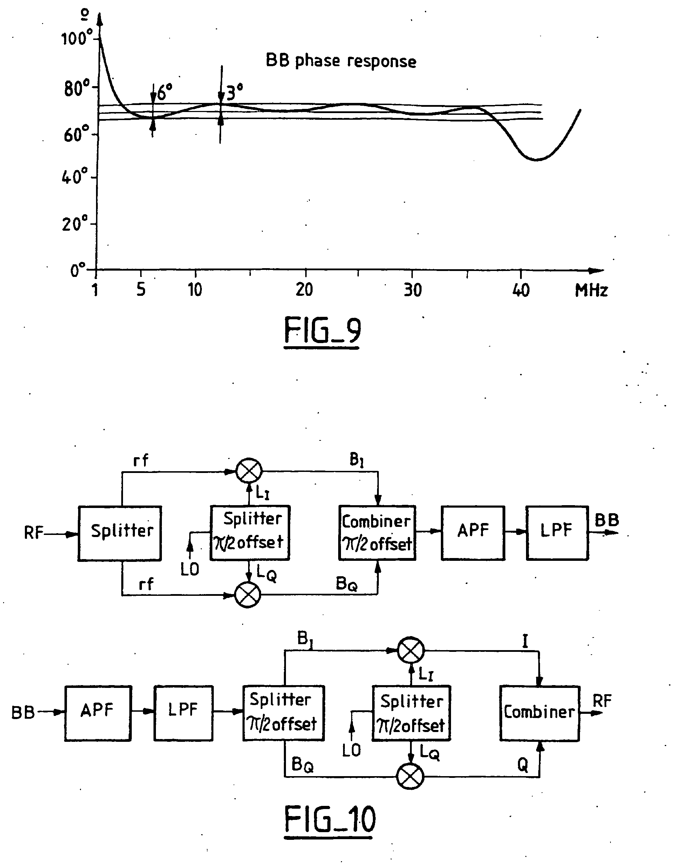

Fig. 9 shows the over all RF to BB phase response of the converter according to the invention. A phase variation of less than $\pm$ 3° is obtained over the frequency band 3-37 MHz, using a phase-shift stage according to Fig. 4a, a low-pass filter (LPF) according to Fig. 5 and an all-pass filter (APF) according to Fig. 4b for phase compensation at two distinct frequencies. The converter assembly is according to the block diagram in Fig. 10, upper drawing, while the corresponding assembly for the conversion from BB to RF is shown in the lower drawing. Compared to the corresponding block diagrams in Figs. 1 and 2 of prior art, two additional blocks are added: the APF and LPF. The invention, however, resides not simply in adding these blocks but merely expanding the prior art technology into much broader bands. This is not apparent from the block diagram but is explained in details in the description and demonstrated by the phase response curve in Fig. 9.

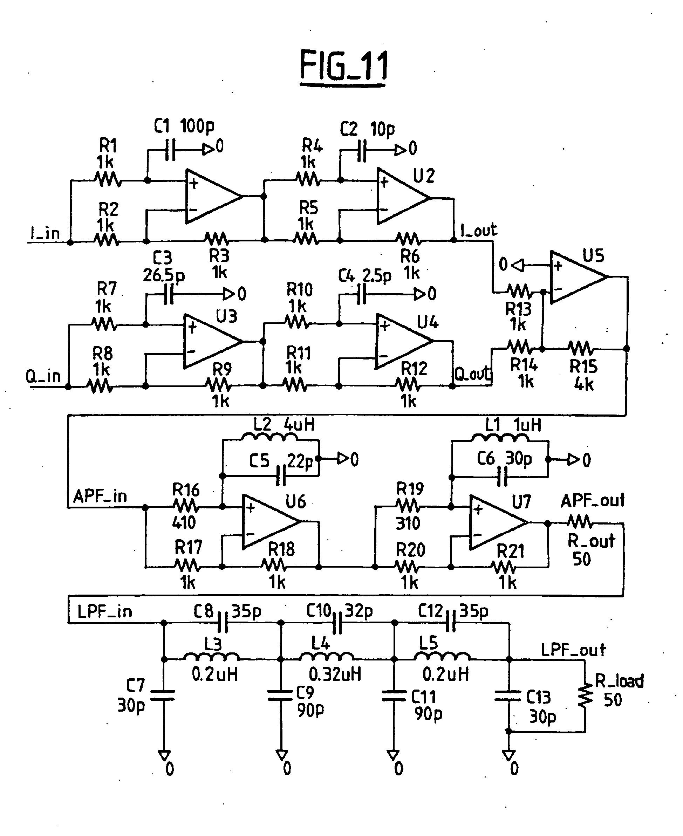

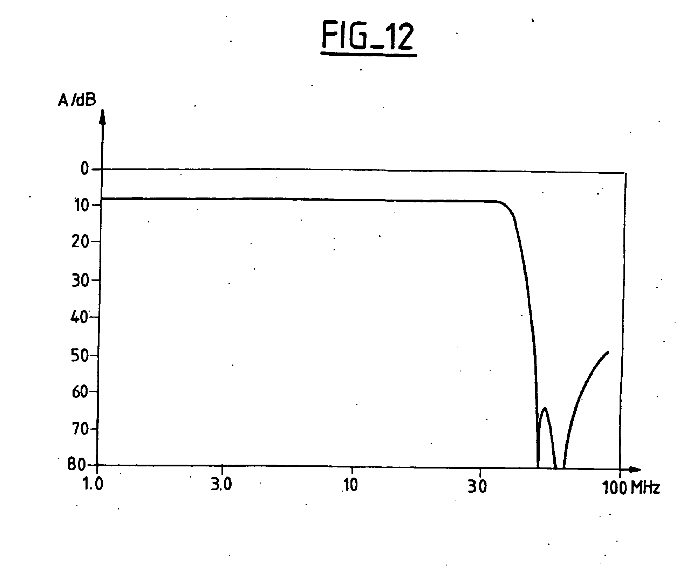

Fig. 11 gives a typical circuit diagram for the three final circuit blocks of Fig. 4c, showing the component values, and the corresponding frequency response of these circuits is illustrated in Fig. 12.

The circuits of Figs. 4a and 4b comprises two and three feedback amplifier stages, respectively, of which the gain is given by the ratio of the feedback resistors connected to the inverting input, while the phase shift is given by the component values of the RC path connected to the amplifier direct input. The typical circuit using opamps is as shown in Fig. 4a and having two equal stages, but evidently it is also within the scope of the present application to have only one stage or more than two stages, equal or staggered. The operational amplifiers used as active elements in the first of the shown circuits are of a resent type having large open loop gain and wide bandwidth in a strong feedback loop. Operational amplifiers of the current feedback high-speed type are preferably used, having a feedback bandwidth well above 40 MHz. The performance is slightly better than of the transistor version of Fig. 4b.

The circuits of Figs. 4c and 4d show typical two- and three-stage all-pass filters (APF); each stage having a resistive feedback in the inverting input path and an RLC combination in the direct input path. The LC combination forms a tuneable resonance circuit of which the resonance frequency is chosen where a maximum phase shift is to occur. More than two stages can some times be convenient, and the tuning can be made automatically or semi-automatically in a running production, in order to compensate for the fairly well normalised phase fluctuations over the band of interest.

Excellent level balance, that is an equal signal level in the I and Q channels, is achieved by the use of as few components as possible and a strong feedback given by a minimum number of stable and preferably equal resistors in the feedback loops.

The same is true for the phase balance and stability, and the resulting phase response is primarily compensated for by the opposite or complementary phase response of one single low-pass filter (LPF), said filter additionally giving the required channel selectivity. According to the invention the decreasing phase delay of the I and Q channels over the frequency band (see Fig. 7c: mean values of I and Q) and the gradually increasing phase delay of the LPF (Fig. 7b) partly cancel each other, without the need for introducing further circuits in the I and Q channels and only using a limited number of circuits totally. The final correction of the phase delay is done with the all-pass filter (APF), and thereby a compensation of the phase distortion over a wide band can be made based on the system specifications, independent of the balance requirements, which gives a significant benefit and makes the design less critical.

The adjustment of the balance between the I and Q channels is fairly simple, as the level and phase can be adjusted independently. If necessary, further filtering can be carried out in a high-pass filter to remove the lower frequency BB signal components. A further attenuation of the unwanted sideband and the carrier (LO) can be done for fixed frequencies at RF, preferably with a SAW filter.

It is well known and also discussed in ref. [8] that the distortion of a feedback amplifier can be kept low in an amplifier having a constant open loop slope or by strong feedback.

## Claims

1. A phase-linear wide band converter for frequency conversion from a multi-octave baseband BB to an RF band and utilising I/Q signal processing, comprising :

  a phase linear wide band RF power combiner having a main output port, a first divisional input port and a second divisional input port,
  an I/Q mixer stage having a local oscillator LO, an I/Q wide band power divider comprising an LO input port, a divisional I output port for an in-phase LO signal ($L_I$) and a divisional Q output port for a quadrature phase LO signal (L_Q), and two wide band balanced mixers for receiving the LO signals, respectively, at a first input port and for receiving an input I/Q signal (B_I, B_Q) at a second input port, **characterised by** impedance matching circuits,

a wide band BB I/Q power divider having a main input port, an in-phase divisional I output port and a quadrature phase divisional Q output port, the divisional output ports of said divider comprising active wide band amplifier stages each having a reactive branch at one input, so as to provide a means for phase shift without introducing amplitude response variations versus frequency,

a single BB low-pass filter (LPF) having a predetermined phase response versus frequency, and

a BB phase correction stage, said low-pass filter (LPF) and phase correction stage being connected in series in the BB signal path at the converter input. for filtering out unwarted inter-modulation products.

2. A phase-linear wide band converter for frequency conversion from an RF band to a multi-octave baseband BB and utilising I/Q signal processing, comprising :

   a phase linear wide band RF power divider having a main input port, a first divisional output port and a second divisional output port,

   an I/Q mixer stage having a local oscillator LO, an I/Q wide band power divider comprising an LO input port, a divisional I output port for an in-phase LO signal (L_I) and a divisional Q output port for a quadrature phase LO signal (L_Q), and two wide band balanced mixers for receiving the LO signals, respectively, at a first input port and for receiving an input signal (rf) at a second input port,

   impedance matching circuits, **characterized by**

   a wide band BB I/Q power combiner having a main output port, an in-phase divisional I input port and a quadrature phase divisional Q input port, the divisional input ports of said combiner comprising active wide band amplifier stages each having a reactive branch at one input, so as to provide a means for phase shift without introducing amplitude response variations versus frequency,

   a single BB low-pass filter (LPF) having a predetermined phase response versus frequency, and

   a BB phase correction stage,

   said low-pass filter (LPF) and phase correction stage being connected in series in the BB signal path at the converter output.

3. A wide band converter according to claim 1 or 2, **characterised in that** the baseband phase correction stage comprises at least one active circuit having a resistive feedback and a reactive input branch so as to act as an all-pass filter (APF).

4. A wide band converter according to one of the preceding claims, **characterised in that** the active BB I/Q power divider or combiner comprises at least one amplifier having resistive feedback and a resistive/capacitive (RC) phase shift circuit so as to present a predetermined increasing phase response versus frequency.

5. A wide band converter according to one of the preceding claims, **characterised in that** the BB low-pass filter (LPF) is a three-stage ladder filter designed for the optimising of phase linearity, phase response and pass-band flatness.

6. A wide band converter according to one of the preceding claims, **characterised in that** the baseband (BB) phase correction stage is comprising two operational amplifiers, each having a resistive feedback at the inverting input and a parallel resonance circuit from the direct input to ground, thereby providing a two-stage all-pass filter (APF) adapted to match the BB low-pass filter and correct overall phase fluctuations.

7. A wide band converter according to one of the preceding claims 3, 4 and 6, **characterised in that** the resistive feedback comprises resistors adapted for laser beam trimming in a test set-up for automatic performance measurements.

**Patentansprüche**

1. Phasenlinearer Breitbandumsetzer zur Frequenzumsetzung von einem Multioktaven-Basisband BB in ein HF-Band, der eine I/Q-Signalverarbeitung nutzt, mit:

   einem phasenlinearen Breitband-HF-Leistungskombinator, der einen Hauptausgangsanschluß, einen ersten Teilungseingangsanschluß und einen zweiten Teilungseingangsanschluß aufweist,

einer I/Q-Mischstufe, die aufweist: einen Überlagerungsoszillator LO, einen I/Q-Breitbandleistungsteiler, der einen LO-Eingangsanschluß, einen I-Teilungsausgangsanschluß für ein phasengleiches LO-Signal ($L_I$) und einen Q-Teilungsausgangsanschluß für ein um 90° phasenverschobenes LO-Signal ($L_Q$) aufweist, und zwei symmetrische Breitbandmischer jeweils zum Empfang der LO-Signale an einem ersten Eingangsanschluß und zum Empfang eines I/Q-Eingangssignals ($B_I$, $B_Q$) an einem zweiten Eingangsanschluß, Impedanzanpassungsschaltungen,

**gekennzeichnet durch**

einen Breitband-BB-I/Q-Leistungsteiler, der einen Haupteingangsanschluß, einen phasengleichen I-Teilungsausgangsanschluß und einen um 90° phasenverschobenen Q-Teilungsausgangsanschluß aufweist, wobei die Teilungseingangsanschlüsse des Teilers aktive Breitbandverstärkerstufen aufweisen, die jeweils einen Reaktanzzweig an einem Eingang aufweisen, so daß sie eine Einrichtung zur Phasenverschiebung bereitstellen, ohne Frequenz-Amplitudengangvariationen einzuführen,

einen einzelnen BB-Tiefpaßfilter (LPF), der einen vorbestimmten Frequenz-Phasengang aufweist, und eine BB-Phasenkorrekturstufe,

wobei der Tiefpaßfilter (LPF) und die Phasenkorrekturstufe im BB-Signalweg am Umsetzereingang zum Ausfiltern unerwünschter Intermodulationsprodukte in Reihe geschaltet sind.

2. Phasenlinearer Breitbandumsetzer zur Frequenzumsetzung von einem HF-Band in ein Multioktaven-Basisband BB, der eine I/Q-Signalverarbeitung nutzt, mit:

einem phasenlinearen Breitband-HF-Leistungsteiler, der einen Haupteingangsanschluß, einen ersten Teilungsausgangsanschluß und einen zweiten Teilungsausgangsanschluß aufweist,

einer I/Q-Mischstufe, die aufweist: einen Überlagerungsoszillator LO, einen I/Q-Breitband-Leistungsteiler, der einen LO-Eingangsanschluß, einen I-Teilungsausgangsanschluß für ein phasengleiches LO-Signal ($L_1$) und einen Q-Teilungsausgangsanschluß für ein um 90° phasenverschobenes LO-Signal ($L_Q$) aufweist, und zwei symmetrische Breitbandmischer jeweils zum Empfang der LO-Signale an einem ersten Eingangsanschluß und zum Empfang eines Eingangssignals (rf) an einem zweiten Eingangsanschluß, Impedanzanpassungsschaltungen,

**gekennzeichnet durch**

einen Breitband-BB-I/Q-Leistungskombinator, der einen Hauptausgangsanschluß, einen phasengleichen I-Teilungseingangsanschluß und einen um 90° phasenverschobenen Q-Teilungseingangsanschluß aufweist, wobei die Teilungseingangsanschlüsse des Kombinators aktive Breitbandverstärkerstufen aufweisen, die jeweils einen Reaktanzzweig an einem Eingang aufweisen, so daß sie eine Einrichtung zur Phasenverschiebung bereitstellen, ohne Frequenz-Amplitudengangvariationen einzuführen,

einen einzelnen BB-Tiefpaßfilter (LPF), der einen vorbestimmten Frequenz-Phasengang aufweist, und eine BB-Phasenkorrekturstufe, wobei der Tiefpaßfilter (LPF) und die Phasenkorrekturstufe im BB-Signalweg am Umsetzerausgang in Reihe geschaltet sind.

3. Breitbandumsetzer nach Anspruch 1 oder 2, **dadurch gekennzeichnet, daß** die Basisband-Phasenkorrekturstufe mindestens eine aktive Schaltung aufweist, die eine ohmsche Rückkopplung und einen Reaktanzeingangszweig aufweist, so daß sie als ein Allpaßfilter (APF) dient.

4. Breitbandumsetzer nach einem der vorhergehenden Ansprüche, **dadurch gekennzeichnet, daß** der aktive BB-I/Q-Leistungsteiler oder -Kombinator mindestens einen Verstärker aufweist, der eine ohmsche Rückkopplung und einen ohmschen/kapazitiven (RC) Phasenschieberkreis aufweist, so daß er einen vorbestimmten zunehmenden Frequenz-Phasengang präsentiert.

5. Breitbandumsetzer nach einem der vorhergehenden Ansprüche, **dadurch gekennzeichnet, daß** der BB-Tiefpaßfilter (LPF) ein dreistufiger Abzweigfilter ist, der zur Optimierung der Phasenlinearität, des Phasengangs und der Durchlaßbereichebenheit bestimmt ist.

6. Breitbandumsetzer nach einem der vorhergehenden Ansprüche, **dadurch gekennzeichnet, daß** die Basisband-(BB)-Phasenkorrekturstufe zwei Operationsverstärker aufweist, die jeweils am invertierenden Eingang eine ohmsche Rückkopplung und vom direkten Eingang nach Masse einen Parallelresonanzkreis aufweisen, wodurch ein zweistufiger Allpaßfilter (APF) bereitgestellt wird, der angepaßt ist, den BB-Tiefpaßfilter anzupassen und Gesamtphasenfluktuationen zu korrigieren.

7. Breitbandumsetzer nach einem der vorhergehenden Ansprüche 3, 4 und 6, **dadurch gekennzeichnet, daß** die ohmsche Rückkopplung Widerstände aufweist, die zum Laserstrahlabgleich in einem Meßaufbau für automatische Leistungsmessungen angepaßt sind.

**Revendications**

1. Convertisseur à large bande linéaire en phase pour une conversion de fréquence à partir d'une bande de base BB multioctave vers une bande RF et utilisant un traitement de signal I/Q, comprenant :

   un combineur de puissance à large bande RF linéaire en phase ayant un port de sortie principal, un premier port d'entrée de division et un second port d'entrée de division,
   un étage mélangeur I/Q ayant un oscillateur local LO, un diviseur de puissance à large bande I/Q comprenant un port d'entrée LO, un port de sortie de division I pour un signal LO en phase $L_I$) et un port de sortie U de division pour un signal ($L_Q$) LO en quadrature de phase, et deux mélangeurs à large bande équilibrés pour recevoir les signaux LO, respectivement, à un premier port d'entrée et pour recevoir un signal ($B_I$, $B_Q$) d'entrée I/Q à un second port d'entrée,
   des circuits d'adaptation d'impédance,
   **caractérisé par**
   un diviseur de puissance à large bande BB I/Q ayant un port d'entrée principal, un port de sortie I de division en phase et un port de sortie Q de division en quadrature de phase, les ports de sortie de division dudit diviseur comprenant des étages d'amplification actifs à large bande, chacun ayant une branche réactive à une entrée, de façon à fournir un moyen de décalage de phase sans introduire de variations de réponse d'amplitude en fonction de la fréquence,
   un filtre passe-bas unique BB (LPF) ayant une réponse de phase prédéterminée en fonction de la fréquence, et un étage de correction de phase BB, ledit filtre passe-bas (LPF) et l'étage de correction de phase étant connectés en série dans le trajet du signal BB à l'entrée du convertisseur pour filtrer les produits d'intermodulation non désirés.

2. Convertisseur à large bande linéaire en phase pour une conversion de fréquence à partir d'une bande RF vers une bande de base multi-octave BB et utilisant un traitement de signal I/Q,
   comprenant :

   un diviseur de puissance RF à large bande linéaire en phase ayant un port d'entrée principal, un premier port de sortie de division et un second port de sortie de division,
   un étage mélangeur I/Q ayant un oscillateur local LO, un diviseur de puissance à large bande I/Q comprenant un port d'entrée LO, un port de sortie I de division pour un signal ($L_I$) LO en phase, et un port de sortie Q de division pour un signal ($L_Q$) LO en quadrature de phase, et deux mélangeurs équilibrés à large bande pour recevoir les signaux LO, respectivement, à un premier port d'entrée et pour recevoir un signal d'entrée (rf) à un second port d'entrée,
   des circuits d'adaptation d'impédance,
   **caractérisé par**
   un combineur de puissance I/Q à large bande BB ayant un port de sortie principal, un port d'entrée I de division en phase et un port d'entrée Q de division en quadrature de phase, les ports d'entrée de division dudit combineur comprenant des étages d'amplification actifs à large bande chacun ayant une branche réactive à une entrée, de façon à fournir un moyen pour un décalage de phase sans introduire des variations de réponse d'amplitude en fonction de la fréquence,
   un filtre passe-bas unique BB (LPF) ayant une réponse de phase prédéterminée en fonction de la fréquence, et un étage de correction de phase BB,
   ledit filtre passe-bas (LPF) et l'étage de correction de phase étant connectés en série dans le trajet du signal BB à la sortie du convertisseur.

3. Convertisseur à large bande selon la revendication 1 ou 2 **caractérisé en ce que** l'étage de correction de phase en bande de base comprend au moins un circuit actif ayant une rétroaction résistive et une branche d'entrée réactive de façon à agir comme un filtre passe-tout (APF).

4. Convertisseur à large bande selon l'une des revendications précédentes, **caractérisé en ce que** le diviseur ou combineur de puissance actif I/Q BB comprend au moins un amplificateur ayant une réaction résistive et un circuit de décalage de phase résistif/capacitif (RC) de façon à présenter une réponse de phase croissante prédéterminée en fonction de la fréquence.

5. Convertisseur en bande de base selon l'une des revendications précédentes, **caractérisé en ce que** le filtre passe-bas (LPF) BB est un filtre à échelle à trois étages agencé pour l'optimisation de la linéarité de phase, la réponse de phase et le caractère plat du filtrage passe-bande.

6. Convertisseur en bande de base selon l'une des revendications précédentes, **caractérisé en ce que** l'étage de correction de phase en bande de base (BB) comprend deux amplificateurs opérationnels, chacun ayant une réaction résistive à l'entrée inverseuse et un circuit de résonance parallèle depuis l'entrée directe jusqu'à la masse, fournissant ainsi un filtre passe-tout à deux étages (APF) agencé pour l'adaptation du filtre passe-bas BB et pour la correction des fluctuations globales de phase.

7. Convertisseur en bande de base selon l'une des revendications précédentes 3, 4 et 6 **caractérisé en ce que** la réaction résistive comprend des résistances agencées pour un réglage au faisceau laser dans un banc de test pour les mesures automatiques de performance.

## FIG_1

BB → | Splitter π/2 offset |

B_I → ⊗ ← L_I → I

| Splitter π/2 offset | ← LO

L_Q

B_Q → ⊗ → Q

| Combiner | → RF

## FIG_2

RF → | Splitter |

rf → ⊗ ← L_I → B_I

| Splitter π/2 offset | ← LO

L_Q

rf → ⊗ → B_Q

| Combiner π/2 offset | → BB

## FIG_3

FIG_4a

FIG_4b

FIG_4c

## FIG_4d

## FIG_5

L P F

## FIG_6

FIG_7a

FIG_7b

ΔT/ns

10ns/div  REF 18.93ns    3.:-114.39ps
                         20.000.000MHz

                         1. 30.941ns
                              3MHz
                         2. 10.056ns
                              10MHz
                         4. -5.4083ns
                              37MHz

+40

+20

0

-20

0    10    20    30    40    50    MHz

**FIG_7c**

°

100°

I/Q phase balance by two-stage amplifier

95°

90°

85°

80°

2    3         10         30    50   MHz

**FIG_8**

FIG_9

FIG_10

# FIG_11

# FIG_12